# EUROPÄISCHE PATENTANMELDUNG

(11) **EP 0 527 321 A1**
(43) Veröffentlichungstag der Anmeldung: **17.02.1993**
(21) Anmeldenummer: 92111228.0
(22) Anmeldetag: 02.07.1992
(51) Int. Cl.: G01R 31/302

(54) **Verfahren zur automatischen Fehlerdiagnose von elektrischen Baugruppen**

(30) Priorität: 05.08.1991 EP 91113148
(71) Anmelder: SIEMENS AKTIENGESELLSCHAFT, D-80333 München (DE)
(72) Erfinder: Sauter, Herbert, Dipl.-Ing., W-8000 München 71 (DE)

(57) **Zusammenfassung**

Die Fehlerdiagnose von elektrischen Baugruppen erfolgt bisher durch kostspielige Diagnoseeinrichtungen.

Aufgrund der berührungslosen Aufnahme des elektromagnetischen Strahlungsbildes einer mit Testsignalen beaufschlagten Baugruppe ist der Verschleiß der Meßeinrichtung gering und damit die Zuverlässigkeit des Fehlerdiagnosesystems über eine lange Betriebszeit gewährleistet.

## Beschreibung

Die Fehlerdiagnose von elektrischen Baugruppen erfolgt bisher unter Anwendung unterschiedlichster Methoden. Diese Methoden beruhen auf einem manuell, teilautomatisch oder automatisch durchgeführten SOLL/IST-Vergleich von visuellen, elektrischen oder thermischen Eigenschaften einer Baugruppe oder eines Schaltungskomplexes. Zur Durchführung der genannten Methoden sind jeweils kostspielige Diagnoseeinrichtungen und zeitintensive Prozeduren erforderlich. Außerdem weisen alle bekannten Methoden verfahrensbedingte Schwächen auf, die unter Umständen zu Fehldiagnosen führen. Insbesondere ein Verfahren, bei dem Miniaturnadeln an die Rückseite einer elektrischen Baugruppe herangeführt werden, um auf diese Weise interne Schaltungspunkte der elektrischen Baugruppe abzutasten, ist sehr verschleißanfällig.

Der Erfindung liegt die Aufgabe zugrunde, die genannten Nachteile zu vermeiden.

Diese Aufgabe wird durch die Merkmale des Anspruchs 1 gelöst.

Aufgrund der berührungslosen Aufnahme des elektromagnetischen Strahlungsbildes der mit Testsignalen beaufschlagten Baugruppe ist der Verschleiß der Meßeinrichtung gering und damit die Zuverlässigkeit des Fehlerdiagnosesystems über eine lange Betriebszeit gewährleistet.

Die Figur zeigt eine spezielle Anordnung zur Durchführung des erfindungsgemäßen Verfahrens.

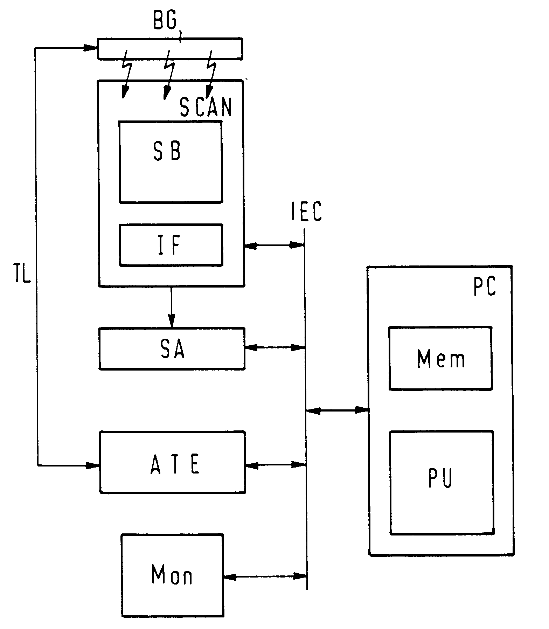

Die Anordnung gemäß FIG 1 umfaßt eine Funktionstesteinrichtung ATE, die den Funktionstest der Baugrppe durchführt, eine elektromagnetische Meßeinrichtung SCAN, die das tatsächliche elektromagnetische Strahlungsbild der zu untersuchenden Baugruppe aufnimmt und an einen spectrum analyzer SA weitergibt, sowie eine workstation PC, die das erfindungsgemäße Verfahren steuert und das Ergebnis der Fehlerdiagnose anschließend über eine Anzeigeeinrichtung Mon anzeigt.

Mit Hilfe der Funktionstesteinrichtung ATE werden über eine Testleitung TL einer zu untersuchenden elektrischen Baugruppe BG Testsignale im Rahmen von mehreren Testzyklen zugeführt, sowie die aufgrund der Stimulation durch die Testsignale sich einstellenden Ergebnissignale empfangen und mit den in der Funktionstesteinrichtung erzeugten Sollsignalen verglichen. Treten bei dem genannten Vergleich Unterschiede zwischen Ergebnissignalen und Sollsignalen auf, meldet die Funktionstesteinrichtung an die workstation PC das Auftreten eines Fehlers.

Die workstation veranlaßt daraufhin die Funktionstesteinrichtung den Testablauf zu unterbrechen und den sich bei Auftreten des Fehlers im Gange befindlichen Testzyklus zyklisch zu wiederholen.
Gleichzeitig aktiviert die workstation die elektromagnetische Meßeinrichtung zur Aufnahme des elektromagnetischen Strahlungsbildes der fehlerbehafteten Baugruppe. Die workstation kann durch einen Standardcomputer mit entsprechenden Programmen realisiert sein. Die genannten Programme werden dabei in einer Speichereinrichtung Mem gespeichert und von einer Verarbeitungseinheit PU abgearbeitet.

Die elektromagnetische Meßeinrichtung besteht aus einer flächenartigen Sensoreinrichtung SB, die eine Antennenmatrix mit winzigen Antennen und eine Abtasteinrichtung beinhaltet, durch die das von den Antennen empfangene elektromagnetische Strahlungsbild abgetastet, in digitale Signale umgewandelt und an den spectrum analyzer SA zur Auswertung weitergegeben wird. Ein Standardinterface IF sorgt für den Anschluß der elektromagnetischen Meßeinrichtung SCAN an einen Standardbus IEC und dient somit der Kommunikation zwischen workstation und elektromagnetischer Meßeinrichtung.

Das vom spectrum analyzer SA während der Wiederholung des Testzyklus ermittelte tatsächliche elektromagnetische Strahlungsbild der fehlerbehafteten Baugruppe wird nach Ablauf des Testzyklus an die workstation übertragen.

In der workstation wird das tatsächliche elektromagnetische Strahlungsbild mit dem bei der Durchführung des Testzyklus erwarteten elektromagnetischen Strahlungsbild verglichen. Um diesen Vergleich durchführen zu können, sind in der Speichereinrichtung Mem der workstation die für jeden Testzyklus jeweils erwarteten elektromagnetischen Strahlungsbilder einer fehlerfreien Baugruppe abgespeichert.

Die erwarteten elektromagnetischen Strahlungsbilder müssen vor der Durchführung des erfindungsgemäßen Verfahrens anhand einer fehlerfreien Baugruppe für jeden Testzyklus aufgenommen und in der Speichereinrichtung Mem der workstation abgespeichert worden sein.

Im Fehlerfall kann also durch den genannten Vergleich, der mit Hilfe eines entsprechenden Programms durchgeführt wird, die geografische Lage der Unterschiede zwischen den beiden Strahlungsbildern ermittelt werden. Da in der genannten Speichereinrichtung auch die Bestückungsinformation der Baugruppe, d. h. die geografische Lage der Bauelemente und Leitungszüge auf der Baugruppe abgespeichert ist, können so mit Hilfe der Bestückungsinformation und der Lage der genannten Unterschiede die durch den Fehler betroffenen Bauteile und Leitungszüge ermittelt und durch die Anzeigeeinrichtung Mon ausgegeben werden. Bei der Anzeigeeinrichtung Mon kann es sich z.B. um einen Monitor oder einen Drucker handeln.

## Patentansprüche

1. Verfahren zur automatischen Fehlerdiagnose von elektrischen Baugruppen (BG), demgemäß
a) die Eingänge der zu prüfenden Baugruppe im Rahmen von mehreren Testzyklen mit Testsignalen beaufschlagt werden,
b) die sich aufgrund der Beaufschlagung an den Ausgängen einstellenden Ergebnissignale mit gespeicherten Sollsignalen verglichen werden,
c) bei Ungleichheit zwischen Ergebnis - und Sollsignalen der betreffende Testzyklus zyklisch wiederholt, und das hierbei auftretende elektromagnetische Strahlungsbild der zu prüfenden Baugruppe gemessen wird,
d) das gemessene elektromagnetische Strahlungsbild mit dem entsprechenden elektromagnetischen Strahlungsbild einer fehlerfreien Baugruppe verglichen wird,
e) aufgrund der örtlichen Lage der Unterschiede zwischen den beiden elektromagnetischen Strahlungsbildern die fehlerbehafteten Bauteile und/oder Leitungszüge der zu überprüfenden Baugruppe ermittelt und angezeigt werden.
